(19) Europäisches Patentamt
European Patent Office
Office européen des brevets

(11) Veröffentlichungsnummer: **0 104 143**
**B1**

(12) # EUROPÄISCHE PATENTSCHRIFT

(45) Veröffentlichungstag der Patentschrift: **29.10.86**

(21) Anmeldenummer: **83810411.5**

(22) Anmeldetag: **12.09.83**

(51) Int. Cl.⁴: **C 08 K 5/04,** C 08 G 85/00, C 08 G 59/68, C 08 F 2/50, G 03 C 1/68

(54) **Diaryljodosylsalze enthaltende photopolymerisierbare Zusammensetzungen.**

(30) Priorität: **18.09.82 GB 8226707**
**10.06.83 GB 8315926**

(43) Veröffentlichungstag der Anmeldung: **28.03.84 Patentblatt 84/13**

(45) Bekanntmachung des Hinweises auf die Patenterteilung: **29.10.86 Patentblatt 86/44**

(84) Benannte Vertragsstaaten: **BE CH DE FR GB IT LI NL SE**

(56) Entgegenhaltungen:
**THE JOURNAL OF ORGANIC CHEMISTRY, Band 33, Nr. 7, Juli 1968, Seiten 2981-2984, Easton (USA);**

(73) Patentinhaber: **CIBA-GEIGY AG, Klybeckstrasse 141, CH-4002 Basel (CH)**

(72) Erfinder: **Irving, Edward, Dr., 41, Swaffham Road, Burwell Cambridge CB5 0AN (GB)**

**EP 0 104 143 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Vorliegende Erfindung betrifft aus einem kationisch polymerisierbaren Material und einem Diaryljodosylsalz bestehende Zusammensetzungen sowie die Polymerisation solcher Zusammensetzungen mittels aktinischer Strahlung und deren Verwendung als Oberflächenüberzüge, bei der Herstellung von Druckplatten und gedruckten Schaltungen und als Klebstoffe.

Bekannterweise ist es wünschenswert, die Polymerisation in organischen Materialien mittels aktinischer Strahlung einzuleiten. Mit solchen Verfahren kann man beispielsweise die Verwendung toxischer und/oder brennbarer Lösungsmittel mit ihren begleitenden Problemen der Umweltbelastung und der Rückgewinnungskosten vermeiden. Photopolymerisation ermöglicht es, die Unlöslichmachung von Harzzusammensetzungen auf bestimmte Stellen zu beschränken, d.h. die bestrahlten Stellen, und gestattet daher die Herstellung von gedruckten Schaltungen und Druckplatten bzw. erlaubt es, die Verklebung von Substraten auf die gewünschten Zonen zu begrenzen. Ferner sind Bestrahlungsverfahren häufig schneller als solche, bei denen Erhitzen und folglich eine Abkühlungsstufe erforderlich sind.

Die Verwendung aromatischer Jodoniumsalze als Photopolymerisationskatalysatoren für kationisch polymerisierbare Materialien ist schon bekannt.

So beschreibt die britische Patentschrift Nr. 1 516 351 härtbare Zusammensetzungen, die aus (A) einem zu einem höheren Molekulargewichtszustand polymerisierbaren Monoepoxid, Epoxidharz oder einem Gemisch von diesen und (B) einem strahlungsempfindlichen Haloniumsalz in einer Menge bestehen, welche die Härtung von (A) durch Freisetzung eines sauren Katalysators bei Belichtung mit Strahlungsenergie bewirken kann.

Typische solche aromatische Haloniumsalze sind Diphenyljodonium-tetrafluoroborat, -hexafluorophosphat, -hexafluoroantimonat und -hexafluoroarsenat.

In der britischen Patentschrift Nr. 1 491 539 sind photopolymerisierbare Zusammensetzungen beschrieben, die aus (A) einem kationisch polymerisierbaren organischen Material und (B) 0,5 bis 30 Teilen auf 100 Gewichtsteile organisches Material eines aromatischen Jodoniumkomplexsalzphotoinitiators der Formel

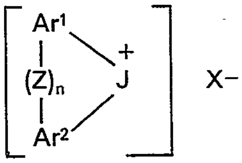

I

worin $Ar^1$ und $Ar^2$ aromatische Gruppen mit 4 bis 20 Kohlenstoffatomen, wie gegebenenfalls substituierte oder gegebenenfalls mit einem oder mehreren Benzoringen kondensierte Phenyl-, Thienyl-, Furanyl- oder Pyrazolylgruppen, und Z ein Sauerstoff- oder Schwefelatom oder eine Gruppe der Formel

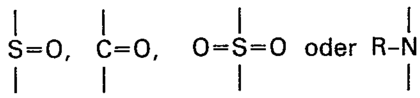

(wobei R für –H, eine Niederalkylgruppe oder eine Carbonsäureacylgruppe steht), eine direkte Kohlenstoff-Kohlenstoffbindung oder eine Gruppe der Formel

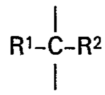

(wobei $R^1$ und $R^2$ je für –H, Alkyl oder Alkenyl stehen) bedeuten, n null oder 1 ist und $X^-$ ein Tetrafluoroborat-, Hexafluorophosphat-, Hexafluoroarsenat-, Hexachloroantimonat- oder Hexafluoroantimonatanion darstellt, bestehen.

Die angeführten kationisch polymerisierbaren organischen Materialien umfassen Oxetane, Lactone, Vinyläther und Mono- oder Polyepoxide, und als typische Jodoniumkomplexsalze sind wiederum Diphenyljodonium-tetrafluoroborat, -hexachloroantimonat, -hexafluorantimonat und -hexafluorophosphat angegeben.

Aus der britischen Patentschrift Nr. 1 539 192 sind photopolymerisierbare Zusammensetzungen bekannt, die mindestens ein säurepolymerisierbares oder säurehärtbares Material und als Photosensibilisator mindestens ein Jodoniumsalz der Formel

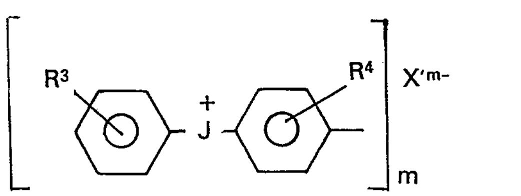

II

worin m 1 oder 2 ist, $R^3$ und $R^4$ je für ein Wasserstoff- oder Halogenatom, eine Nitrogruppe, eine gegebenenfalls substituierte Kohlenwasserstoffgruppe oder eine heterocyclische Gruppe und $X'^{m-}$ für ein sich von einer zur Polymerisation oder Härtung des säurepolymerisierbaren oder säurehärtbaren Materials fähigen Säure ableitendes Anion stehen, enthalten. Geeignete säurepolymerisierbare oder säurehärtbare Materialien sind dabei Epoxide, Episulfide, Phenolharze, Aminoplaste und Poly-(N-methylol)-derivate von Polycarbonsäureamiden wie Polyacrylamid, und als Jodoniumsalze eignen sich unter anderem Diphenyljodonium-tetrafluoroborat, 4,4'-Dimethyldiphenyljodonium-hydrogensulfat und 4,4'-Dichlordiphenyljodonium-hexafluoroarsenat.

Weitere Patentschriften beschreiben die Photopolymerisation spezieller Materialtypen in Gegenwart eines Diaryljodoniumsalzes. Beispielsweise ist in der britischen Patentschrift Nr. 1 565 671 und der entsprechenden U.S. Patentschrift Nr. 4 256 828 eine Zusammensetzung beschrieben, die aus einem Polyepoxid, einer organischen Hydroxylverbindung mit einer Hydroxylfunktionalität von 1 oder höher, wie einem Alkylenglycol, und als Photoinitiator einem Salz der Formel I besteht.

Aus der britischen Patentschrift Nr. 1 554 389 und der entsprechenden U.S. Patentschrift Nr. 4 193 799 sind photohärtbare Zusammensetzungen bekannt, die aus einem Epoxidharz, einem Polyvinylacetal und einem aromatischen Oniumsalz bestehen, wobei der letztere Begriff Jodoniumsalze wie Diphenyljodonium-hexafluoroarsenat umfassen soll.

Die U.S. Patentschrift Nr. 4 090 936 beschreibt photohärtbare flüssige Zusammensetzungen, die aus einer Epoxidverbindung mit einer Durchschnittsepoxidfunktionalität von 1 bis 1,3, einem verträglichen Polymer mit einer Glasübergangstemperatur von 20 bis 105°C, nämlich einem Acrylat- oder Methacrylatpolymer, einem Styrol/Allylalkoholcopolymer oder Polyvinylbutyral, und als Photoinitiator einem aromatischen Komplexsalz bestehen, wobei letzterer Begriff die Diaryljodoniumsalze der Formel I umfassen soll.

Die belgische Patentanmeldung Nr. 880 959 beschreibt lagerfähige, UV-härtbare Epoxi-silanzusammensetzungen, die als Photoinitiator ein Diaryljodoniumsalz der Formel

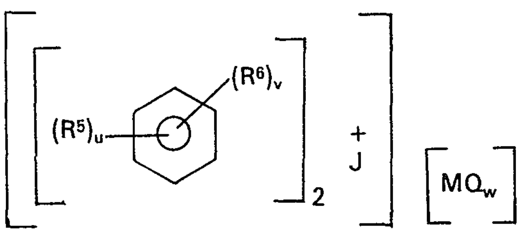

III

worin $R^5$ für eine Alkyl- oder Halogenalkylgruppe mit 4 bis 20 Kohlenstoffatomen, $R^6$ für eine Alkylgruppe mit 1 bis 3 Kohlenstoffatomen, eine Alkoxygruppe mit 1 bis 8 Kohlenstoffatomen, eine Nitrogruppe oder ein Halogenatom, M für ein Metall- oder Metalloidatom und Q für ein Halogenatom stehen, u 1 bis 4 und v null oder 1 bis 3, derart dass (u+v) = 1 bis 4 und w 4 bis 6 sind, enthalten.

Aus der U.S. Patentschrift Nr. 4 227 978 sind photohärtbare Zusammensetzungen bekannt, die aus einem halogenierten oligomeren Ester, wie einem sich von Tetrachlorphthalsäureanhydrid und Äthylenglykol ableitenden Ester, einem Acrylat- oder Methacrylatmonomer, wie Butandiolacrylat, einem kationischen Initiator wie Diphenyljodonium-hexafluorophosphat, einer Epoxidverbindung und einem Radikalinitiator wie Diäthoxyacetophenon bestehen.

In der britischen Patentschrift Nr. 2 073 760 sind strahlungshärtbare Zusammensetzungen beschrieben, die ein Dihydropyran und als bei Belichtung mit Strahlung eine Säure freisetzenden Katalysator ein Aryljodonium-, Aryldiazonium- oder Arylsulfoniumsalz enthalten.

Schliesslich offenbaren die britische Patentschrift Nr. 1 535 492 und die entsprechende U.S. Patentschrift Nr. 4 108 747 härtbare Zusammensetzungen, die aus einem kationisch polymerisierbaren Material, wie einem Gemisch aus einem Epoxinovolak und 4-Vinylcyclohexendioxyd oder Diäthylenglykoldivinyläther zusammen mit einem strahlungsempfindlichen Sulfonat bestehen, wobei letzterer Begriff Jodoniumsulfonate der Formel

$$\left[ R^7_p\, R^8_q\, \overset{+}{J} \right] \left[ X''\, SO_3^- \right] \qquad IV$$

worin $R^7$ für eine aromatische einwertige Gruppe und $R^8$ für eine aromatische zweiwertige Gruppe stehen, p null oder 2 und q null oder 1 sind, derart dass eines von p und q, aber nicht beide, null sind, und X'' eine aromatische Kohlenwasserstoffgruppe mit 6 bis 13 Kohlenstoffatomen, eine Alkyl- oder Halogenalkylgruppe mit 1 bis 8 Kohlenstoffatomen oder Fluor bedeutet, einschliesst.

In einem Artikel von F. M. Beringer und P. Bodlaender, J. Org. Chem., 1968, 33, 2981-4 sind verschiedene Diaryljodosylsalze und deren Herstellung beschrieben. Dieser Artikel gibt jedoch keinen Hinweis auf das Verhalten solcher Salze, wenn sie aktinischer Strahlung ausgesetzt werden, und gibt auch keine mögliche Verwendung für diese an.

Überraschenderweise wurde nun gefunden, dass gewisse Jodsalze, in denen sich das Jod in einem höheren Oxydationszustand befindet, d.h. Diaryljodosylsalze, auch als Photoinitiatoren wirken werden, da sie bei Belichtung mit UV-Licht eine Art saure Verbindung freisetzen. Keine der Veröffentlichungen des Standes der Technik legt es nah, dass ein Jodosylsalz diese wertvolle Eigenschaft besitzen würde.

Die Jodoniumsalze des Standes der Technik sollen auch Heisshärtungs- oder Heisspolymerisationskatalysatoren sein. Dagegen besitzen die Jodosylsalze in den erfindungsgemässen Zusammensetzungen beim Erhitzen in Abwesenheit aktinischer Strahlung nur eine schwache oder gar keine Wirkung auf Verbindungen, die unter der Einwirkung eines kationischen Katalysators in höhermolekulares Material umgewandelt werden können. So trat bei 48 Stunden Erhitzen auf 150°C keine Gelierung einer 2 Gewichtsteile Diphenyljodosyl-hexafluorophosphat und 100 Gewichtsteile des am weitesten verwendeten Epoxidharzes [2,2-Bis-(4-glycidyloxyphenyl)-propan] enthaltenden Zusammensetzung ein. Daraus folgt, dass erfindungsgemässe Zusammensetzungen wünschenswert lange Topfzeiten aufweisen, wenn sie vor aktinischer Strahlung geschützt sind. Gegenstand dieser Erfindung sind dementsprechend photopolymerisierbare Zusammensetzungen, die mindestens ein kationisch polymerisierbares Material und als Photoinitiator mindestens ein Diaryljodosylsalz der Formel

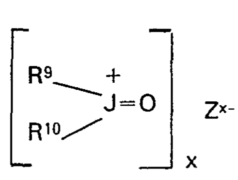

V

worin $R^9$ und $R^{10}$ gleich oder verschieden sein können und je einen unsubstituierten oder Substituenten, welche die Freisetzung einer sauren Verbindung bei Bestrahlung des Diaryljodosylsalzes nicht stören, enthaltenden einwertigen aromatischen Rest mit 4 bis 25 Kohlenstoffatomen darstellen, x 1, 2 oder 3 ist und $Z^{x-}$ ein x-wertiges Anion einer Protonensäure bedeutet, enthalten.

Geeignete Anionen $Z^{x-}$ sind solche, die sich von organischen Carbonsäuren ableiten, wie Acetate und Trifluoracetate, solche, die sich von organischen Sulfonsäuren $Y{-}SO_3H$, worin Y einen gegebenenfalls einfach oder mehrfach durch Halogenatome substituierte aliphatische, aromatische oder aliphatisch-substituierte aromatische Gruppe mit vorzugsweise 1 bis 20 Kohlenstoffatomen bedeutet, ableiten, wie Methansulfonate, Benzolsulfonate, Toluol-p-sulfonate und Trifluormethansulfonate, und solche, die sich von anorganischen Säuren ableiten, typischerweise Halogenide wie Fluoride, Chloride und Bromide, Halogenate wie Jodate, Perhalogenate wie Perchlorate sowie Nitrate, Sulfate, Hydrogensulfate, Phosphate, Hydrogensulfate, Phosphate, Hydrogenphosphate und komplexe Anionen wie Pentafluorohydroxoantimonate und solche der Formel $MY_W^-$, worin M für ein Metall- oder Metalloidatom und Q für ein Halogenatom stehen und w eine ganze Zahl von 4 bis 6 und um eins grösser als die Wertigkeit von M ist.

Bei der Belichtung dieser neuartigen Zusammensetzungen mit Strahlung geeigneter Wellenlänge setzt der Photoinitiator der Formel V eine Art saure Verbindung frei, die Polymerisation oder Vernetzung der Zusammensetzung bewirkt. Gegenstand dieser Erfindung ist daher ein Verfahren zur Herstellung polymeren oder vernetzten Materials, welches dadurch gekennzeichnet ist, dass man eine aus mindestens einem kationisch polymerisierbaren Material und einem Photoinitiator der Formel V bestehende photopolymerisierbare Zusammensetzung der Strahlung einer solchen Wellenlänge aussetzt, dass der Photoinitiator aktiviert und die Zusammensetzung polymerisiert oder vernetzt wird.

Bei der im erfindungsgemässen Verfahren verwendeten Strahlung kann es sich ausschliesslich um Ultraviolettstrahlung oder auch um Strahlung mit Wellenlängen sowohl im ultravioletten als auch im sichtbaren Spektralbereich handeln. Die Zusammensetzungen können ferner Farbstoffe enthalten, so dass sie für verschiedene sichtbare Spektralbereiche empfindlich sind. Geeignete Farbstoffe sind beispielsweise in der U.S. Patentschrift Nr. 4 026 705 offenbart, und diese sind üblicherweise kationisch, wie Acridingelb, Acridinorange, Phosphin R, Benzoflavin, Setoflavin T und deren Gemische.

Der bevorzugte Wellenlängenbereich der im erfindungsgemässen Verfahren angewandten Strahlung liegt im Bereich von 200 bis 600 nm, insbesondere 200 bis 400 nm.

In den Diaryljodosylsalzen der Formel V sind die Gruppen $R^9$ und $R^{10}$ vorzugsweise gleich und stellen gegebenenfalls substituierte mono-, di- oder tri-homocyclische oder heterocyclische aromatische Gruppen dar. Beispiele für geeignete heterocyclische aromatische Gruppen sind Thienyl-, Furyl-, Pyridyl- und Pyrazolylgruppen. Geeignete tricyclische aromatische Gruppen sind beispielsweise Anthryl-, Phenanthryl- und Fluorenylgruppen, während als geeignete mono- und dicyclische aromatische Gruppen Phenyl- und Naphthylgruppen sowie Gruppen der Formel

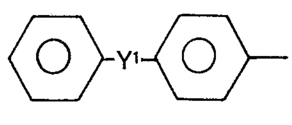

VI

worin $Y^1$ für eine Kohlenstoff-Kohlenstoffbindung, ein Äthersauerstoffatom oder eine Gruppe der Formel $-CH_2-$ oder $-C(CH_3)_2-$ steht, in Frage kommen. All diese aromatischen Gruppen können gegebenenfalls einfach oder mehrfach durch Atome oder Gruppen substituiert sein, welche die Freisetzung einer Art sauren Verbindung bei der Bestrahlung des Diaryljodosylsalzes nicht stören. Typische solche Substituenten sind unter anderem Alkyl- und Alkoxygruppen mit 1 bis 4 Kohlenstoffatomen, Nitrogruppen und Halogenatome. Vorzugsweise stellen $R^9$ und $R^{10}$ beide Phenyl dar und sind gegebenenfalls jeweils an den Phenylringen durch eine Alkylgruppe mit 1 bis 4 Kohlenstoffatomen, insbesondere eine Methyl- oder Isopropylgruppe, ein Halogenatom, insbesondere ein Fluoratom, oder eine Nitrogruppe substituiert.

Die Anionen der Formel $MQ_W$ sind vorzugsweise Polyhalogenide des Antimons, Arsens, Wismuts, Eisens, Zinns, Bors und Phosphors, wie Hexafluoroantimonat, Hexachloroantimonat, Hexafluoroarsenat, Pentachlorowismutat, Tetrachloroferrat, Hexachlorostannat, Tetrafluoroborat oder Hexafluorophosphat, wobei die beiden letztgenannten besonders bevorzugt sind.

Jedes kationisch polymerisierbare Material lässt sich durch Belichtung mit Strahlung in Gegenwart eines geeigneten Diaryljodosylsalzes der Formel V härten oder polymerisieren. Es wird jedoch nicht jedes solche Material durch alle solchen Salze gehärtet, und die genaue Art des Materials und des Anions Z ist dabei kritisch und muss für wirksame Härtung entsprechend ausgewählt werden. Die Abstimmung eines kationisch polymerisierbaren Materials mit einem geeigneten Anion gehört durchaus zum Wissen eines Fachmanns in der Härtung oder Polymerisation kationisch polymerisierbarer Zusammensetzungen. Beispielsweise sind sich von organischen Carbonsäuren, organischen Sulfonsäuren und anorganischen Säuren ableitende Anionen enthaltende Salze, insbesondere Acetate, Trifluoracetate, Methansulfonate, Benzolsulfonate, Toluol-p-sulfonate, Trifluormethansulfonate, Fluoride, Chloride, Bromide, Jodate, Perchlorate, Nitrate, Sulfate, Hydrogensulfate, Phosphate oder Hydrogenphosphate, zur Härtung von Phenoplasten wie Phenol/Formaldehydharzen und Aminoplasten wie Harnstoff/Formaldehyd- und Melamin/Formaldehydharzen befähigt. Ein Metall- oder Metalloidhalogenidanion enthaltende Salze können Epoxidharze oder Episulfidharze härten bzw. Mono-1,2-epoxide, Monoepisulfide oder Vinyläther polymerisieren. Weitere durch Bestrahlung in Gegenwart eines Jodoniumsalzes, wie in den bei der Würdigung des Standes der Technik hierin angeführten Patentschriften erwähnt, härtbare oder polymerisierbare Materialien lassen sich durch Bestrahlung in Gegenwart eines geeigneten Diaryljodosylsalzes der Formel V härten bzw. polymerisieren.

Als erfindungsgemäss verwendetes kationisch polymerisierbares Material kommen beispielsweise ein Oxetan, ein Thiiran oder ein Tetrahydrofuran in Betracht. Vorzugsweise handelt es sich um ein 1,2-Monoepoxid oder -episulfid mit 2 bis 20 Kohlenstoffatomen, wie Äthylenoxyd, Äthylensulfid, Propylenoxyd oder Propylensulfid, ein Epoxidharz, insbesondere einen Polyglycidyläther eines Bisphenols, ein Phenoplast, ein Aminoplast wie ein Harnstoff/Formaldehyd- oder Melamin/Formaldehydharz oder eine sonstige Methylolverbindung wie ein Poly-(N-methylol)-derivat eines Polycarbonsäureamids. Kationisch polymerisierbare, äthylenisch ungesättigte Materialien, wie Diketen, Vinyläther, Vinylcarbazol oder Styrol sind ebenfalls verwendbar.

Die in den Zusammensetzungen vorliegende Menge Diaryljodosylsalz ist im allgemeinen nicht entscheidend, da nur katalytische Mengen erforderlich sind, um die Härtung oder Photopolymerisation in Gang zu bringen. Im allgemeinen setzt man dabei 0,01 bis 10 Gew.% und vorzugsweise 0,5 bis 5 Gew.%, bezogen auf das Gewicht des kationisch polymerisierbaren Materials, ein.

Zu weiteren Materialien, die in die erfindungsgemässen Zusammensetzungen eingearbeitet werden können, gehören Verdünnungsmittel, insbesondere flüssige Verdünnungsmittel, Füllstoffe wie Kieselsäure, Talkum, Glasmikroballons, Tone, gepulverte Metalle oder Zinkoxyd, Viskositätsregler, wie Asbest, und Kautschuke, Klebrigmacher sowie Pigmente.

Vorzugsweise enthalten die erfindungsgemässen Zusammensetzungen ferner einen photochemischen Radikalbildner oder einen Photosensibilisator. Es wurde gefunden, dass man durch Einarbeitung geeigneter solcher Beschleuniger die Härtungsgeschwindigkeit weiter steigern und dadurch die Anwendung kürzerer Belichtungszeiten und/oder weniger energiereicher Strahlungsquellen ermöglichen kann. Aromatische Carbonylverbindungen sind als Radikalbildner besonders bevorzugt. Diese sind zwar schon zur Radikalpolymerisation äthylenisch ungesättigter Verbindungen verwendet worden, doch ist es überraschend, dass sie die kationische Polymerisation beschleunigen.

Zu geeigneten aromatischen Carbonylverbindungen zählen Ketale aromatischer Diketone, insbesondere Verbindungen der Formel

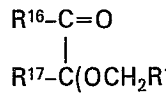

VII

oder

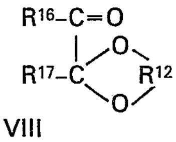

VIII

worin $R^{11}$ für ein Wasserstoffatom, eine Alkylgruppe mit 1 bis 5 Kohlenstoffatomen, eine Alkenylgruppe mit 2 oder 3 Kohlenstoffatomen, eine Aralkylgruppe mit 7 bis 9 Kohlenstoffatomen, eine Aralkenylgruppe mit 8 oder 9 Kohlenstoffatomen oder eine Gruppe der Formel $-(CH_2)-_mR^{13}$, $R^{12}$ für eine Gruppe der Formel $-CH_2CH(R^{15})-$ oder $-CH_2CH(R^{15})CH_2-$ und $R^{13}$ für ein Halogenatom oder eine Gruppe der Formel $-OR^{14}$, $-SR^{14}$, $-OR^{18}$, $-SR^{18}$, $-COOR^{14}$ oder $-COOR^{14}$ stehen, m 1, 2 oder 3 ist und $R^{14}$ eine Alkylgruppe mit 1 bis 4 Kohlenstoffatomen, $R^{15}$ ein Wasserstoffatom oder eine Alkylgruppe mit 1 bis 18 Kohlenstoffatomen sowie $R^{16}$, $R^{17}$ und $R^{18}$ je unabhängig voneinander eine gegebenenfalls durch bis zu 3 unter Halogenatomen, Alkyl- oder Alkoxygruppen mit 1 bis 4 Kohlenstoffatomen und Phenylgruppen ausgewählte Substituenten substituierte Phenylgruppe bedeuten.

Beispiele für Verbindungen der Formel VII sind Benzildimethylketal, Benzildiäthylketal, Benzil-di-(2-methoxyäthyl)-ketal und Benzil-di-(2-chloräthyl)-ketal. Verbindungen der Formel VIII sind beispielsweise 2-Phenyl-2-benzoyl-4-methyl-1,3-dioxolan und 2-Phenyl-2-benzoyl-1,3-dioxan. Benzildimethylketal ist als solche aromatische Carbonylverbindung besonders bevorzugt.

Verbindungen der Formel VII oder VIII sind in der britischen Patentschrift Nr. 1 390 006 beschrieben, wo sie zur Photopolymerisation und Photovernetzung äthylenisch ungesättigter Verbindungen wie Methylacrylat, styrolhaltigen Polyestern auf Maleinsäuregrundlage und Diallylphthalatpräpolymerer eingesetzt werden.

Weitere zur Verwendung als Photobeschleuniger geeignete Substanzen sind unter anderem aromatisch-aliphatische Ketone einer der Formeln

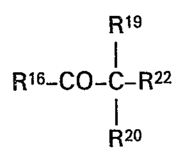

IX

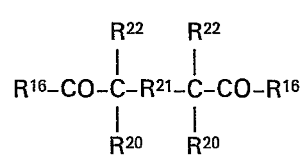

X

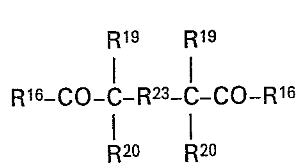

XI

und

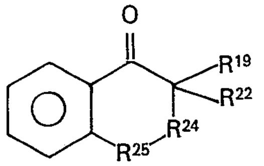

XII

worin $R^{16}$ die oben angegebene Bedeutung hat, $R^{19}$ und $R^{20}$ je für eine einwertige aliphatische, cycloaliphatische oder araliphatische Gruppe stehen oder zusammen mit dem daran gebundenen Kohlenstoffatom eine Cycloalkylengruppe bedeuten können und $R^{21}$ eine Kohlenstoff-Kohlenstoffbindung oder einen zweiwertigen organischen Rest, $R^{22}$ eine Hydroxyl- oder Aminogruppe oder eine einwertige verätherte oder silylierte solche Gruppe, $R^{23}$ eine zweiwertige Amino-, Äther- oder Siloxygruppe, $R^{24}$ eine direkte chemische Bindung oder $-CH_2-$ und $R^{25}$ -O-, -S-, $-SO_2-$, $-CH_2-$, oder $-C(CH_3)_2-$darstellen.

Diese Verbindungen, zu deren bevorzugten Mitgliedern 2-Allyloxy-2-methylpropiophenon, 2-Benzyloxy-2-methylpropiophenon, 2-Hydroxy-2-methyl-p-phenoxypropiophenon, 1-Benzoylcyclohexanol, 1-Benzoylcyclopentanol und Bis-[4-(α-hydroxyisobutyryl)-phenyl]-äther gehören, sind in der europäischen Patentanmeldung Nr. 0 003 002 ebenfalls als Photopolymerisationskatalysatoren für äthylenisch ungesättigte Verbindungen und als Photovernetzer für Polyolefine beschrieben.

Weitere, zur Erhöhung der Photopolymerisationsgeschwindigkeit mit Salzen der Formel V verwendbare Verbindungen sind 2-substituierte Thioxanthone der Formel

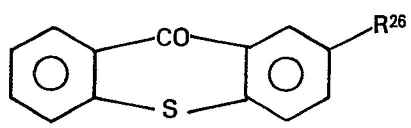

XIII

worin $R^{26}$ entweder ein Chloratom oder eine Alkylgruppe mit 1 bis 6 Kohlenstoffatomen wie eine Isopropyl- oder tert.- Butylgruppe bedeutet. Verbindungen der Formel XIII, insbesondere die 2-Chlorverbindung, werden industriell als Photopolymerisationskatalysatoren für äthylenisch ungesättigte Verbindungen und als Photovernetzer für Polyolefine eingesetzt.

Bevorzugt werden 30 bis 125 Gew.%, und insbesondere 50 bis 100 Gew.%, des Photobeschleunigers, berechnet auf das Gewicht des Diaryljodosylsalzes der Formel V, mitverwendet.

Die Zusammensetzungen können ferner Photosensibilisatoren wie Polyarylene (z.B. Perylen und 9,10-Diäthoxyanthracen), Polyarylpolyene, 2,5-Diarylisobenzofurane, 2,5-Diarylfurane, 2,5-Diarylthiofurane, 2,5-Diarylpyrrole, 2,5-Diarylcyclopentadiene, Polyarylphenylene, Cumarin und Polyaryl-2-pyrazoline enthalten.

Diaryljodosylsalze der Formel V lassen sich nach einer Methode ähnlich wie von F. M. Beringer und P. Bodlaender, a.a.O., beschrieben, herstellen. Ein Jodaren der Formel XIV wird mit Peressigsäure zum entsprechenden Jodoxyaren der Formel XV oxydiert. Behandlung des Jodoxyarens oder eines Gemisches von zwei Jodoxyarenen mit einem Alkalihydroxyd liefert das Jodosylhydroxyd der Formel XVI, das sich durch Behandlung mit Kohlendioxyd in das Carbonat der Formel XVII überführen lässt. Dieses Hydroxyd bzw. Carbonat wird mit einer Säure der Formel $H_xZ$ (falls solche Säuren existieren) zur Bildung des gewünschten Salzes behandelt. (Direkte Neutralisation des Jodosylhydroxyds ergibt manchmal niedrigere Ausbeuten des gewünschten Salzes als bei vorhergehender Überführung in das Carbonat.) Wo solche Säuren im freien Zustand nicht existieren oder schwer zu handhaben sind, kann man das Hydroxyd oder Carbonat z.B. mit Essigsäure oder Trifluoressigsäure zum entsprechenden Acetat der Formel XVIII bzw. Trifluoracetat der Formel XIX umsetzen. Ein solches Salz wird mit einem Alkali- oder Ammoniumsalz der Säure $H_xZ$, z.B. einem Phosphat, Hexafluorophosphat, Tetrachloroferrat oder Hexafluoroantimonat, behandelt, um das gewünschte Produkt der Formel V durch doppelte Umsetzung zu ergeben. Diese Reaktionen sind in dem nachstehenden Schema erläutert.

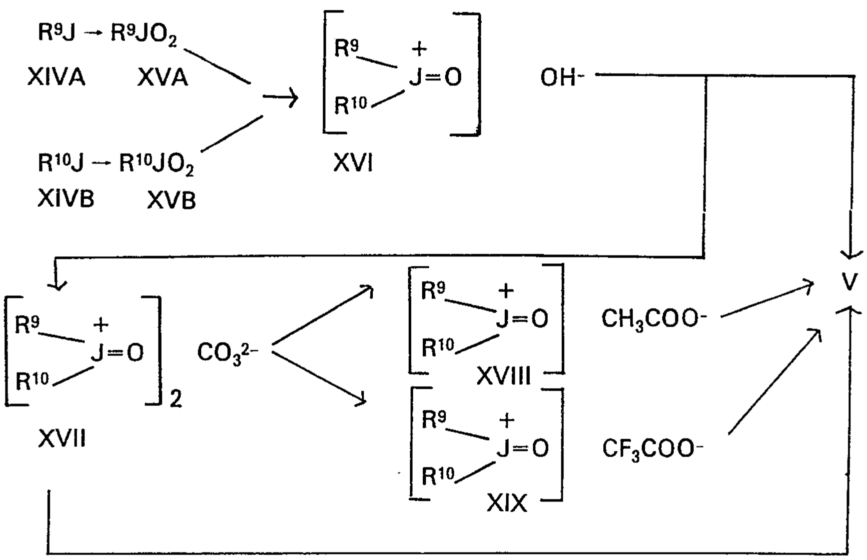

Hexafluoroantimonate sind durch Zusatz festen Natrium- oder Kaliumhexafluoroantimonats zu einer wässrigen Lösung des Jodosylacetats bzw. -trifluoracetats herstellbar; wird das Natrium- oder Kaliumsalz zunächst in Wasser gelöst, dann ist das isolierte Produkt wegen Hydrolyse das Hydroxopentafluoroantimonat ($Z^{x-}$ = $SbF_5(OH)^-$).

Gewünschtenfalls kann man die erfindungsgemässen Zusammensetzungen durch Bestrahlung teilweise härten und die Härtung durch Erhitzen vervollständigen. Für ein solches zweistufiges Härtungsverfahren ist es erforderlich, dass die Zusammensetzung einen hitzeaktivierbaren Härter für das härtbare Material enthält. Solche hitzeaktivierbare Härter sind bekannt, und es liegt im Rahmen der Fähigkeiten eines Fachmanns in Härtungsverfahren, einen für das jeweilige härtbare Material geeigneten Heisshärter auszuwählen. Unter diesen Umständen ist es natürlich wichtig, dass die Bestrahlung bei einer Temperatur unterhalb derjenigen ausgeführt wird, bei der eine wesentliche Heisshärtung des photopolymerisierten Produkts mittels des Heisshärters eintreten würde.

Die erfindungsgemässen Zusammensetzungen sind als Oberflächenüberzüge verwendbar. Sie lassen sich auf eine Unterlage wie Stahl, Aluminium, Kupfer, Cadmium, Zink, Papier oder Holz, vorzugsweise als Flüssigkeit, aufbringen und werden dann bestrahlt oder erhitzt. Durch teilweise Photopolymerisation des Überzugs, wie mittels Bestrahlung durch eine Maske hindurch, können die unbelichteten Stellen zur Entfernung der nicht polymerisierten Anteile mit einem Lösungsmittel ausgewaschen werden, wobei die photopolymerisierten, unlöslichen Anteile an Ort und Stelle bleiben. Die erfindungsgemässen Zusammensetzungen lassen sich somit zur Herstellung von Druckplatten und gedruckten Schaltungen verwenden. Methoden zur Herstellung von Druckplatten und gedruckten Schaltungen aus photopolymerisierbaren Zusammensetzungen sind wohlbekannt (siehe z.B. die britische Patentschrift Nr. 1 495 746 der Anmelderin).

Die Zusammensetzungen sind auch als Klebstoffe einsetzbar. Eine Schicht der Zusammensetzung kann zwischen zwei Oberflächen von Gegenständen eingebracht werden, der Aufbau wird dann bestrahlt und gewünschtenfalls erhitzt, um die Polymerisation zu Ende zu führen. Dabei ist es natürlich erforderlich, dass mindestens einer der Gegenstände für aktinische Strahlung durchlässig ist, z.B. aus Glas besteht.

Die Zusammensetzungen sind auch bei der Herstellung von faserverstärkten Verbundstoffen, einschliesslich vorgemischten Formmassen nützlich.

Sie können direkt und kontinuierlich oder diskontinuierlich in flüssiger Form auf Verstärkungsfasern (einschliesslich Spinnfäden, Filamente und Whiskers) aufgebracht werden, die als Gewebe oder Vlies, unidirektionale Längen oder geschnittene Spinnfäden, insbesondere aus Glas, Bor, Edelstahl, Wolfram, Tonerde, Siliciumcarbid, Asbest oder Kaliumtitanatwhiskers, einem aromatischen Polyamid wie Poly(m-phenylenisophthalamid), Poly-(p-phenylenterephthalamid) oder Poly-(p-benzamid), Polyäthylen, Polypropylen oder Kohlenstoff vorliegen können. Der faserverstärkte Verbundstoff kann auch nach einem Chargenverfahren oder kontinuierlich aus Folien der photopolymerisierbaren Zusammensetzung hergestellt werden. Beim chargenweisen Verfahren wird das fasrige Verstärkungsmaterial auf eine zweckmässig unter einer geringen Spannung stehende Folie aus der photopolymerisierten Zusammensetzung aufgelegt, gegebenenfalls wird eine zweite solche Folie darübergelegt, und der Aufbau wird dann unter Erhitzen verpresst. Der Verbundstoff lässt sich auch kontinuierlich herstellen, z.B. indem man das fasrige Verstärkungsmaterial mit einer Folie der photopolymerisierten Zusammensetzung in Berührung bringt, dann gewünschtenfalls eine zweite solche Folie auf die Rückseite des fasrigen Verstärkungsmaterials legt und Hitze und Druck einwirken lässt. Einfacher ist es, zwei solche, vorzugsweise auf der Rückseite durch Bänder oder abziehbare Bögen abgestützte Folien gleichzeitig so auf das fasrige Verstärkungsmaterial aufzubringen, dass es mit jeder belichteten Fläche in Berührung kommt. Bei Aufbringung zweier solcher Folien können diese gleich oder verschieden sein.

Mehrschichtige Verbundstoffe lassen sich durch Druckerhitzung zwischengeordneter Folien und Schichten aus einem oder mehreren fasrigen Verstärkungsmaterialien herstellen. Bei Verwendung unidirektioneller Fasern als Verstärkungsmaterial können aufeinanderfolgende Schichten von diesen so orientiert werden, dass sie verkreuzte Schichtstrukturen ergeben.

Mit dem fasrigen Verstärkungsmaterial kann man zusätzliche Verstärkungstypen wie eine Metallfolie (z.B. Aluminium, Stahl oder Titan) oder eine Folie aus Kunststoff (z.B. einem aromatischen oder aliphatischen Polyamid, einem Polyimid, Polysulfon oder Polycarbonat) oder einem Kautschuk (z.B. einem Neopren- oder Acrylnitrilkautschuk) mitverwenden. Bei der Herstellung von vorgemischten Formmassen wird eine erfindungsgemässe Zusammensetzung zusammen mit dem Verstärkungsmaterial aus geschnittenen Fasern und weiteren Komponenten der Bestrahlung in Schichten durch Stützbögen hindurch ausgesetzt. Die polymerisierbare Zusammensetzung wird vorzugsweise so aufgetragen, dass der Verbundstoff insgesamt 20 bis 80 Gew.-% dieser Zusammensetzung sowie entsprechend 80 bis 20 Gew.-% Verstärkung enthält. Besonders bevorzugt werden insgesamt 30 bis 50 Gew.-% der Zusammensetzung eingesetzt.

Die erfindungsgemässen Zusammensetzungen sind zur Herstellung von Kitten und Füllstoffen verwendbar. Man kann sie für Tauchbeschichtungen einsetzen, wobei ein zu beschichtender Gegenstand in die flüssige Zusammensetzung eingetaucht, herausgenommen und die anhaftende Beschichtung dann zur Photopolymerisation (und somit Verfestigung) bestrahlt und danach gewünschtenfalls erhitzt wird.

Es wurde gefunden, dass es bei der Verwendung von Diaryljodosylsalzen der Fomel V möglich ist, Epoxidharze und Phenoplaste in zwei Stufen zu härten; das Harz wird zunächst durch Belichtung mit aktinischer Strahlung in Gegenwart eines solchen Diaryljodosylsalzes und eines latenten, hitzeaktivierbaren Vernetzungsmittels für das Epoxidharz oder Phenoplast in die teilweise gehärtete B-Stufe überführt und in einem zweiten Schritt wird die teilweise gehärtete Zusammensetzung so erhitzt, dass die Härtung mittels des hitzeaktivierbaren Vernetzungsmittels vervollständigt wird. Somit kann man eine halbflüssige Zusammensetzung herstellen, die sich dann verformen oder zum Tränken eines Substrats mit gleichzeitiger Bestrahlung zu dessen Verfestigung verwenden lässt; der verfestigte Körper wird dann gewünschtenfalls erhitzt, um die Härtung des Harzes zu vervollständigen.

Gemäss einer weiteren Ausführungsform dieser Erfindung wird daher ein Epoxidharz oder ein Phenoplast in Gegenwart einer zu dessen Polymerisation wirksamen Menge eines Diaryljodosylsalzes der Fomel V und eines latenten Härters dafür zur Bildung eines B-Stufenprodukts bestrahlt, und gewünschtenfalls wird die Härtung der Zusammensetzung durch Erhitzen vervollständigt.

Eine weitere Ausführungsform umfasst eine ein Epoxidharz oder Phenoplast, eine zu dessen Polymerisation bei Belichtung der Zusammensetzung mit aktinischer Strahlung wirksame Menge eines Diaryljodosylsalzes der Formel V und eine härtende Menge eines latenten Härters für das Epoxidharz oder Phenoplast enthaltende Zusammensetzung.

Zu geeigneten hitzeaktivierbaren Vernetzungsmitteln für die Epoxidharzzusammensetzungen zählen Polycarbonsäureanhydride, Komplexe von Aminen, insbesondere primären oder tertiären aliphatischen Aminen wie Aethylamin, Trimethylamin und n-Octyldimethylamin, mit Bortrifluorid oder Bortrichlorid sowie latente Bordifluoridchelate. Aromatische Polyamine und Imidazole sind im allgemeinen nicht vorzuziehen, da man mässige Ergebnisse erzielt, möglicherweise wegen einer Reaktion zwischen dem durch die Säure freigesetzten Katalysator und dem Amin. Dicyandiamid lässt sich erfolgrich einsetzen, vorausgesetzt, dass es in verhältnismässig groben Teilchen vorliegt.

Als hitzeaktivierbare Vernetzungsmittel für Novolake eignen sich unter anderem Hexamethylentetramin und Paraform. Die zur Heisshärtung nach der Photopolymerisation erforderliche Temperatur und Erhitzungsdauer sowie die Anteile an hitzeaktivierbarem Härter lassen sich leicht durch Serienversuche ermitteln oder aus dem bereits wohlbekannten Fachwissen über die Heisshärtung von Epoxidharzen und Phenol/Aldehydnovolaken herleiten.

Zusammensetzungen, die Harze mit Epoxidgruppen oder phenolischen Hydroxylgruppen, über die sie nach der Photopolymerisation heissgehärtet werden können, enthalten, sind besonders nützlich bei der Herstellung von mehrschichtigen gedruckten Schaltungen.

Herkömmlicherweise wird eine mehrschichtige gedruckte Schaltung aus mehreren zweiseitigen bedruckten Leiterplatten aus Kupfer hergestellt, die übereinandergestapelt und voneinander durch isolierende Folien, üblicherweise aus mit einem Epoxidharz oder Phenol/Formaldehydharz in der B-Stufe imprägnierten Glasfasern, getrennt sind. Wird kein Heisshärter in die photopolymerisierbare Harzschicht in der Leiterplatte eingemischt, so kann dieser in die mit den Platten abwechselnden Isolierschichten eingearbeitet werden, die herkömmlicherweise aus einem Epoxidharz- oder Phenol/Formaldehydharzpräpreg bestehen; vorausgesetzt, dass der Präpreg nicht zu dick ist, wandert genügend darin enthaltender Heisshärter aus, um die Vernetzung des photopolymerisierten Epoxidharzes oder Phenol/Formaldehydharzes einzuleiten. Der Stapel wird erhitzt und zur Bindung der Schichten gegeneinander gepresst. Herkömmliche photopolymerisierbare Materialien bilden jedoch keine starken Bindungen mit Kupfer oder mit Harz imprägnierten Glasfaserbögen. Ein das Kupfer noch bedeckender, mit dem Photopolymer gebundener Stapel ist deshalb an sich schwach und kann im Gebrauch auseinanderblättern. Es ist deshalb normale Praxis, nach der Ätzstufe das restliche Photopolymer entweder durch starke Lösungsmittel oder eine mechanische Methode, z.B. Bürsten, zu entfernen. Solch ein Abstreifverfahren kann das Kupfer der gedruckten Schaltung oder die Oberfläche des Schichtkörpers, auf dem diese aufliegt, beschädigen, und es besteht daher ein Bedarf nach einer Methode, bei der die Notwendigkeit einer Entfernung des photopolymerisierten Materials vor dem Verpressen der Platte vermieden würde. Die Gegenwart restlicher Vernetzungsgruppen in den erfindungsgemässen Zusammensetzungen bedeutet, dass beim Verpressen der Platten Vernetzung eintreten kann, was gute Haftung am Kupfer und am harzimprägnierten Glasfasersubstrat ergibt, wodurch die eben erwähnte Notwendigkeit entfällt; ferner erhält man Produkte mit einem höheren Glasübergangspunkt.

Eine weitere Anwendung, bei der es sich um Heisshärtung nach der Photopolymerisation der erfindungsgemässen Zusammensetzungen handelt, besteht beim Wickelverfahren. Dabei wird ein endloses Kabel fasriger Verstärkung mit einer einen latenten Heisshärter enthaltenden Zusammensetzung imprägniert und dann unter Belichtung der Wicklung mit aktinischer Strahlung auf einen Dorn oder Kern aufgewickelt. Solche Fadenwickel besitzen immer noch einen gewissen Grad an Biegsamkeit, so dass sich der Dorn oder Kern leichter entfernen lässt, als wenn eine starre Wicklung in einer Stufe gebildet wird. Erforderlichenfalls wird die Wicklung zur Vernetzung der Zusammensetzung erhitzt.

Bei einer weiteren solchen Anwendung wird eine Schicht der Zusammensetzung in flüssiger

Form bestrahlt, bis sie sich unter Bildung eines Klebfilms verfestigt, der dann zwischen zwei zu verbindende Oberflächen und in Berührung mit diesen eingelegt wird, und der Aufbau wird dann erhitzt, um die Vernetzung der Zusammensetzung zu vervollständigen. Der Film kann dabei auf einer Seite mit einer abziehbaren Schutzfolie, z.B. aus einem Polyolefin oder Polyester oder aus cellulosehaltigem Papier mit einer Silicontrennmittelbeschichtung, versehen sein. Der Aufbau ist häufig leichter zu handhaben, wenn der Film eine klebrige Oberfläche besitzt. Dies lässt sich dadurch erreichen, dass man den Film mit einer Substanz beschichtet, die bei Raumtemperatur klebrig ist, aber unter den zur Vervollständigung der Vernetzung der Zusammensetzung eingesetzten Bedingungen zu einem harten, unlöslichen, unschmelzbaren Harz vernetzt. Ein hinreichendes Mass Klebrigkeit besteht jedoch häufig ohne zusätzliche Behandlung, insbesondere wenn die Polymerisation der Zusammensetzung nicht zu weit fortgeschritten ist. Geeignete Klebsubstrate sind unter anderem Metalle wie Eisen, Zink, Kupfer, Nickel und Aluminium, Keramik, Glas und Kautschuke.

Die nachfolgenden Beispiele erläutern die Erfindung.

Jodosylsalze werden wie folgt hergestellt:

Man gibt Jodoxybenzol (4,72 g) bei 0°C unter kräftigem Rühren zu 1-normaler wässriger Natronlauge (40 ml). Nach 2 Stunden wird das ausgefallene Natriumjodat durch Filtrieren entfernt und Kohlendioxyd durch das Filtrat geperlt, bis die Lösung neutral ist. Dann gibt man zur Freisetzung des Kohlendioxyds langsam 1-normale Essigsäurelösung in geringem Überschuss dazu. Diphenyljodosylacetatmonohydrat wird als weisser Feststoff vom Schmelzpunkt 105–110°C (Zers.) abfiltriert, wobei man 2,76 g erhält.

Dieses Monohydrat (1,87 g) löst man in siedendem Wasser (25 ml). Die Lösung wird mit Entfärbungskohle behandelt und heissfiltriert. Dann setzt man langsam eine gesättigte wässrige Kaliumhexafluorophosphatlösung dazu, bis die Zugabe keinen weiteren Niederschlag mehr ergibt. Dann kühlt man ab, filtriert und trocknet den Rückstand im Vakuum bei Raumtemperatur über Phosphorpentoxyd, was Diphenyljodosylhexafluorophosphat (0,87 g) vom Schmelzpunkt 120–130°C (Zers.) ergibt.

Man gibt Jodoxybenzol (35,4 g) bei 0°C unter kräftigem Rühren zu 1-normaler Natronlauge (300 ml). Nach 2 Stunden wird filtriert und Kohlendioxyd durch das Filtrat geperlt, bis die Lösung neutral ist. Ein Teil dieser Carbonatlösung (100 ml) wird langsam mit Fluoroborsäure (40%) versetzt, bis die Kohlendioxydentwicklung aufhört. Dann gibt man eine weitere Menge der Säure (2 ml) dazu und filtriert den Niederschlag ab, der mit eiskaltem Wasser gewaschen und getrocknet wird, was Diphenyljodosyl-tetrafluoroborat (2,4 g) vom Schmelzbereich 110°–120°C (Zers.) ergibt.

Diphenyljodosyl-trifluoracetat wird nach F.M. Beringer und P. Bodländer, a.a.O., hergestellt.

Bis-(4-methylphenyl)-jodosyl-trifluoracetat (1,16 g; nach F.M. Beringer und P. Bodländer, a.a.O., hergestellt) löst man in siedendem Wasser (10 ml), filtriert und versetzt das Filtrat mit Kaliumhexafluorophosphat (0,49 g) als gesättigte wässrige Lösung. Man dampft das Gemisch auf etwa das halbe Volumen ein und filtriert den Niederschlag ab. Dieser wird dann getrocknet, was Bis-(4-methylphenyl)-jodosyl-hexafluorophosphat (0,68 g) vom Schmelzpunkt 125°C (Zers.) ergibt.

Verfährt man wie oben, jedoch ausgehend von Bis-(4-fluorphenyl)-jodosyl-trifluoracetat (seinerseits nach F.M. Beringer und P. Bodländer, a.a.O., hergestellt), so erhält man Bis-(4-fluorphenyl)-jodosyl-hexafluorophosphat vom Schmelzpunkt 126°C (Zersetzung).

Verfährt man wie oben, jedoch ausgehend von Bis-(4-isopropylphenyl)-jodosyl-trifluoracetat (seinerseits gemäss einer ähnlichen Methode wie nach F.M. Beringer und P. Bodländer, a.a.O., hergestellt), so erhält man Bis-(4-isopropylphenyl)-jodosyl-hexafluorophosphat vom Schmelzpunkt 84°C.

Man löst Diphenyljodosyl-trifluoracetat (1,2 g) in heissem Wasser, behandelt mit Aktivkohle und filtriert heiss. Das Filtrat wird mit wässriger Ammoniumtetrachloroferratlösung (0,7 g) versetzt, wobei sich ein weisser Niederschlag bildet. Dieser wird abfiltriert und getrocknet, was Diphenyljodosyl-tetrachloroferrat vom Schmelzpunkt 164°C ergibt.

Man gibt Jodoxybenzol (11,8 g) unter Rühren zu 1-molarer Natronlauge bei 0°C. Nach 2 Stunden wird das Gemisch filtriert und das Filtrat bei 0°C mit Kohlendioxyd behandelt, bis es neutral ist. Unter kräftigem Rühren gibt man wässrige 4-Toluolsulfonsäurelösung dazu, bis völlige Freisetzung des Kohlendioxyds erreicht ist. Der gebildete Feststoff wird durch Filtrieren gewonnen, mit eiskaltem Wasser gewaschen und im Vakuum über Phosphorpentoxyd getrocknet, was Diphenyljodosyl-4-toluolsulfonat vom Schmelzpunkt 108–110°C ergibt.

Man löst Bis-(4-methylphenyl)-jodosyl-trifluoracetat (F.M. Beringer und P. Bodlaender, a.a.O.) g) in siedendem Wasser (25 ml), behandelt mit Aktivkohle und filtriert heiss. Das Filtrat wird mit gesättigter Natriumchloridlösung versetzt und abgekühlt, wobei sich Kristalle von Bis-(4-methylphenyl)-jodosylchlorid abscheiden. Die Kristalle werden abfiltriert und an der Luft getrocknet, was 0,35 g des Chlorids vom Schmelzpunkt 146°C ergibt.

Man gibt Jodoxybenzol (11,8 g) unter Rühren bei 0°C zu 1-molarer Natronlauge (100 ml) und rührt noch 1½ Stunden bei dieser Temperatur weiter. Zur Entfernung des ausgefallenen Natriumjodats wird das Gemisch dann filtriert. Das Filtrat wird mit 10%iger Orthophosphorsäurelösung bis auf pH 5 versetzt. Kristallisation erfolgt durch Kühlung der Lösung auf 0°C über Nacht. Die Kristalle werden durch Filtrieren gewonnen und an

der Luft getrocknet, was Diphenyljodosylorthophosphat (2,5 g) vom Schmelzpunkt 115–116°C (Zers.) liefert.

Diphenyljodosylsulfat wird wie oben für das Orthophosphat beschrieben hergstellt, jedoch unter Verwendung einer 10%igen Schwefelsäurelösung anstelle der Orthophosphorsäure. Bei der Zugabe der Säure bildet sich ein gelber Niederschlag. Dieser wird abfiltriert und der Feststoff gewonnen. Der gelbliche Feststoff stellt Diphenyljodosylsulfat (2,0 g) vom Schmelzpunkt 126–128°C (Zers.) dar.

Man löst Diphenyljodosyl-trifluoracetat (1,23 g) in 30 ml heissem Wasser, versetzt mit Natriumhexafluoroantimonat (0,78 g) und kühlt die entstandene Lösung über Nacht auf 0°C. Der gebildete weisse kristalline Feststoff wird durch Filtrieren gewonnen, was 0,5 g Diphenyljodosyl-hexafluoroantimonat vom Schmelzpunkt 142–144°C (Zersetzung) liefert.

3-Nitrojodoxybenzol (11,25 g) vom Schmelzpunkt 206°C (Zersetzung), hergestellt in 75%iger Ausbeute durch Oxydation von 3-Nitrojodbenzol mit Peressigsäure, wird unter Rühren bei 0°C zu 1-molarer Natronlauge (80 ml) gegeben. Nach 90 Minuten filtriert man zur Entfernung des ausgefallenen Natriumjodats. Das Filtrat wird mit Hexafluorophosphorsäurelösung (10%) versetzt. Mit der Erniedrigung des pH fällt das Jodosylsalz aus der Lösung aus. Die Säurezugabe wird abgebrochen, wenn der pH etwa 5 erreicht. Der Niederschlag wird durch Filtrieren gewonnen und an der Luft getrocknet. Er stellt Bis-(3-nitrophenyl)-jodosyl-hexafluorophosphat (0,2 g) vom Schmelzpunkt 182°C (Zersetzung) dar.

Die folgenden Harze werden in den Beispielen verwendet:

Harz I bedeutet den Diglycidyläther des 2,2-Bis-(4-hydroxyphenyl)-propans.

Harz II bedeutet 3,4-Epoxicyclohexancarbonsäure-3,4-epoxicyclohexylmethylester.

Harz III bedeutet 1,2-Cyclohexandicarbonsäure-diglycidylester.

Harz IV bedeutet 1,2-Cyclohex-4-endicarbonsäure-diglycidylester.

Harz V bedeutet 3,4-Dihydro-2H-pyran-2-carbonsäure-3,4-dihydro-2H-pyran-2-ylmethylester.

Harz VI bedeutet Hexamethoxymethylmelamin.

Harz VII bedeutet ein aus Phenol und Formaldehyd hergestelltes Resol mit einem Phenol/Formaldehydmolverhältnis von 1:1,43, einer Viskosität von 0,35 Pa.s bei 25°C und einem Feststoffgehalt von 70%.

Harz VIII bedeutet ein Harnstoff-Formaldehydharz mit einem Formaldehyd/Harnstoffmolverhältnis von 1,87:1.

Harz IX bedeutet mit einem bromhaltigen Phenol zu einem Erweichungspunkt von 50°C vorverlängertes Harz I mit einem Epoxidgehalt von 2,0 val/kg.

Harz X bedeutet den Tetraglycidyläther des 1,1,2,2-Tetrakis-(4-hydroxyphenyl)-äthans mit einem Epoxidgehalt von 5,2 val/kg.

Harz XI bedeutet 1,4-Butandiol-diglycidyläther mit einem Epoxidgehalt von 9,4 val/kg.

Harz XII bedeutet ein aus Phenol und Formaldehyd hergestelltes Resol mit einem Phenol/Formaldehydmolverhältnis von 1:1,14, einer Viskosität von 0,7 Pa.s bei 25°C und einem Feststoffgehalt von 76%, mit 4-Toluolsulfonsäure neutralisiert.

Harz XIII bedeutet einen aus 2,2-Bis-(4-hydroxyphenyl)-propan und Formaldehyd hergestellten glycidylierten Novolak mit einem Erweichungspunkt von 72°C und einem Epoxidgehalt von 4,9 val/kg.

Beispiel 1

Man vermischt das Harz (10 g) mit Diphenyljodosylhexafluorophosphat (0,3 g) und Aceton (0,15 ml) und streicht es als 10 µm dicken Überzug auf Weissblech. Der Überzug wird mit einer 80 W/cm-Mitteldruckquecksilberbogenlampe in 20 cm Abstand bestrahlt. Die verwendeten Harze, die Bestrahlungszeiten und die Eigenschaften der bestrahlten Überzüge sind in der nachfolgenden Tabelle angegeben:

Tabelle 1

| Harz | Bestrahlungszeit (Sekunden) | bestrahlter Überzug |
|---|---|---|
| I | 1 | hart, klebfrei |
| II | 1 | hart, klebfrei |
| V | 4 | hart, klebfrei |

Beispiel 2

Man verfährt wie in Beispiel 1, unter Verwendung von Bis-(4-methylphenyl)-jodosyl-hexafluorophosphat (0,2 g), Harz IV (5,02 g) und Aceton (0,15 ml). Der erhaltene Überzug ist nach 20 Sekunden Bestrahlung klebfrei.

Wird Benzildimenthylketal (0,123 g) ebenfalls in die Zusammensetzung eingearbeitet, so wird sie schon nach 8 Sekunden Bestrahlung klebfrei.

Beispiel 3

Man verfährt wie in Beispiel 1, unter Verwendung von Harz I (10 g) und Diphenyljodosyl-tetrafluoroborat (0,3 g). Der Überzug ist nach 30 Sekunden Bestrahlung klebfrei. Bei Einarbeitung von 2-Chlorthiosanthon (0,15 g) wird die Zusammensetzung schon nach 10 Sekunden Bestrahlung klebfrei.

Beispiel 4

Man verfährt wie in Beispiel 1, unter Verwendung von Harz III (5 g) und Bis-(4-methylphenyl)-jodosyl-hexafluorophosphat (0,15 g). Der Überzug wird nach 10 Sekunden Bestrahlung klebfrei. Bei Einarbeitung von Benzildimethylketal (0,15 g) in die Zusammensetzung wird der Überzug schon nach 6 Sekunden Bestrahlung klebfrei.

Beispiel 5

Man verfährt wie in Beispiel 1, unter Verwendung von Diphenyljodosyl-acetat oder -trifluoracetat (0,15 g) und verschiedenen Harzen (5 g). Die Ergebnisse sind in der nachfolgenden Tabelle angeführt.

Tabelle 2

| Harz | Diphenyljodosylsalz | Bestrahlungszeit |
|---|---|---|
| VI | Trifluoracetat | 5 Sekunden |
| VII | Trifluoracetat | 12 Sekunden |
| VIII | Acetat | 6 Sekunden |

Die Phenol- und Harnstoff/Formaldehydharze, d.h. Harze VII bzw. VIII, werden klebfrei, sobald die Bestrahlungszeit endet. Harz VI, ein Melaminharz, muss erhitzt werden, um Härtung mit einer Art saurer Verbindung zu bewirken. Es wird deshalb nach der Bestrahlung 15 Minuten lang auf 120°C erhitzt und wird so klebfrei.

Beispiel 6

Man bereitet eine Harz IX (5 g), Harz X (4 g), Harz I (1 g) und Diphenyljodosyl-hexafluorophosphat (0,2 g) in Cyclohexanon (10 g) enthaltende Lösung. Ein kupferkaschierter Schichtstoff wird mit dieser Zusammensetzung beschichtet und das Lösungsmittel verdunsten gelassen, wobei eine 5 µm dicke Beschichtung verbleibt. Diese wird 6 Minuten durch ein Negativ hindurch mit einer 500 W-Mitteldruckquecksilberlampe in 22 cm Abstand bestrahlt. Nach Entwickeln in 1,1,1-Trichloräthan erhält man eine scharfe, glänzende Reliefabbildung. Die unbeschichteten Kufperstellen werden durch Behandlung mit wässriger Eisen-III-Chloridlösung (40 Gew.-% $FeCl_3$) entfernt, wobei die beschichteten Stellen intakt bleiben.

Beispiel 7

Eine Lösung gemäss Beispiel 6 wird mit 2-Chlorthioxanthon (0,05 g) behandelt und auf einen kupferkaschierten Schichtkörper aufgebracht. Nach Verdunstung des Lösungsmittels verbleibt eine 8 µm dicke Schicht auf der Kupferoberfläche. Diese Schicht wird durch ein Negativ hindurch 10 Sekunden mit einer 5000 W-Metallhalogenidlampe in 75 cm Abstand bestrahlt. Entwickeln in 1,1,1-Trichloräthan liefert eine scharfe, glänzende Abbildung.

Beispiel 8

Man verfährt wie in Beispiel 1, unter Verwendung von Bis-(4-isopropylphenyl)-jodosyl-hexafluorophosphat (0,03 g), Harz I (1,0 g) und γ-Butyrolacton (0,03 g). Die dabei erhaltene Beschichtung wird nach Bestrahlung für 1 Sekunde klebfrei.

Beispiel 9

Man streicht ein Gemisch aus Harz II (50 g), Harz XI (50 g), Bis-(4-fluorphenyl)-jodosyl-hexafluorophosphat (0,3 g) und Aceton (0,3 g) als 8 µm dicken Überzug auf Weissblech. Der Überzug wird mit einer 80 W/cm-Mitteldruckquecksilberbogenlampe in 20 cm Abstand bestrahlt, was nach 5 Sekunden einen klebfreien Überzug ergibt.

Beispiel 10

Harz XII (100 g) und Diphenyljodosyl-tetrachloroferrat (3 g) werden vermischt und auf Weissblech zu einem 6–8 µm dicken Überzug vergossen. Der Überzug wird mit einer 80 W/cm-Mitteldruckquecksilberbogenlampe in 20 cm Abstand bestrahlt, was nach 7 Sekunden einen klebfreien Film ergibt.

Beispiel 11

Man wiederholt Beispiel 10 unter Ersatz des Tetrachloroferrats durch die gleiche Gewichtsmenge Diphenyljodosyl-4-toluolsulfonat. Nach 8 Sekunden erhält man einen klebfreien Film.

Beispiel 12

Beispiel 10 wird wiederholt, jedoch unter Ersatz des Tetrachloroferrats durch die gleiche Gewichtsmenge Bis-(4-methylphenyl)-jodosyl-chlorid. Nach 5 Sekunden erhält man einen klebfreien Film.

Beispiel 13

Man vermahlt Harz XIII (97 g) und Diphenyljodosylhexafluorophosphat (3 g) und passiert sie durch ein Sieb mit 210 µm Maschenweite. Das erhaltene Pulver wird auf einen geladenen kupferkaschierten Schichtkörper aufgestäubt, der dann 3 Minuten auf 100°C erhitzt wird, wodurch die Pulverbeschichtung schmilzt und eine ungefähr 50 µm dicke Schicht verbleibt. Die Schicht wird dann 3 Minuten durch ein Negativ hindurch mit einer 5000 W-Metallhalogenidlampe in 75 cm Abstand bestrahlt. Entwickeln mit 1,1,1-Trichloräthan ergibt eine gute, scharfe Abbildung.

Beispiel 14

Man beschichtet Weissblech mit einem Gemisch aus Harz XII (100 g) und Diphenyljodosylphosphat (3 g) zu einer Dicke von 4–6 µm. Bestrahlung der Beschichtung mit einer 80 W/cm-Mitteldrucklampe in 20 cm Abstand ergibt nach 30 Sekunden einen klebfreien Überzug.

Beispiel 15

Man beschichtet Weissblech mit einem Gemisch aus Harz XII (100 g) und Diphenyljodosylsulfat (3 g) zu einer 6 µm dicken Schicht. 35 Sekunden Bestrahlung in der gleichen Weise wie in Beispiel 14 liefert einen klebfreien Überzug.

Beispiel 16

Man beschichtet Weissblech mit einem Gemisch aus Harz I (100 Gewichtsteile), Aceton (3 Gewichtsteile) und Bis-(3-nitrophenyl)-jodosylhexafluorophosphat (3 Gewichtsteile) zu einer Dicke von 6–8 µm. 10 Sekunden Bestrahlung mit einer 80 W/cm-Mitteldruckquecksilberlampe in 20 cm Abstand liefert einen klebfreien Überzug.

Beispiel 17

Man verfährt wie in Beispiel 1, unter Verwendung von Harz I (10 g), Diphenyljodosyl-hexafluoroantimonat (0,3 g) und Aceton (0,15 ml). Dabei erhält man nach 12 Sekunden Bestrahlung eine klebfreie Oberfläche.

## Patentansprüche

1. Photopolymerisierbare Zusammensetzungen, dadurch gekennzeichnet, dass sie mindestens ein kationisch polymerisierbares Material und als Photoinitiator mindestens ein Diaryljodosylsalz der Formel

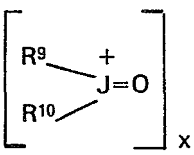 $Z^{x-}$ V

worin $R^9$ und $R^{10}$ gleich oder verschieden sein können und je einen unsubstituierten oder Substituenten, welche die Freisetzung einer sauren Verbindung bei Bestrahlung des Diaryljodosylsalzes nicht stören, enthaltenden einwertigen aromatischen Rest mit 4 bis 25 Kohlenstoffatomen darstellen, x 1, 2 oder 3 ist und $Z^{x-}$ ein x-wertiges Anion einer Protonensäure bedeutet, enthalten.

2. Zusammensetzungen nach Anspruch 1, dadurch gekennzeichnet, dass als Gruppen $R^9$ und $R^{10}$ gegebenenfalls substituierte Thienyl-, Furyl-, Pyridyl-, Pyrazolyl-, Anthryl-, Phenanthryl-, Fluorenyl-, Phenyl- oder Naphthylgruppen oder Gruppen der Formel

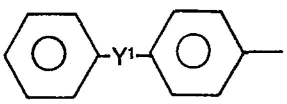 VI

worin $Y^1$ eine Kohlenstoff-Kohlenstoffbindung, ein Aethersauerstoffatom oder eine Gruppe der Formel $-CH_2-$ oder $-C(CH_3)_2-$ darstellt, vorliegen.

3. Zusammensetzungen nach Anspruch 1 oder 2, dadurch gekennzeichnet, dass die Gruppen $R^9$ und $R^{10}$ durch Alkyl- oder Alkoxygruppen mit 1 bis 4 Kohlenstoffatomen, Nitrogruppen oder Halogenatome substituiert sind.

4. Zusammensetzungen nach einem der Ansprüche 1 bis 3, dadurch gekennzeichnet, dass sich das Anion $Z^{x-}$ von einer organischen Carbonsäure, einer organischen Sulfonsäure $Y-SO_3H$, worin Y eine gegebenenfalls durch ein oder mehrere Halogenatome substituierte aliphatische, aromatische oder aliphatisch-substituierte aromatische Gruppe bedeutet, oder einer anorganischen Säure ableitet.

5. Zusammensetzungen nach Anspruch 4, dadurch gekennzeichnet, dass als Anion $Z^{x-}$ ein Acetat, Trifluoracetat, Methansulfonat, Benzolsulfonat, Toluol-p-sulfonat, Trifluormethansulfonat, Fluorid, Chlorid, Bromid, Jodat, Perchlorat, Nitrat, Sulfat, Hydrogensulfat, Phosphat, Hydrogenphosphat oder Pentafluorohydroxoantimonat oder ein Anion der Formel $MQ_w^-$, worin M für ein Metall- oder Metalloidatom und Q für ein Halogenatom stehen sowie w eine ganze Zahl von 4 bis 6 und um eins grösser als die Wertigkeit von M ist, vorliegt.

6. Zusammensetzungen nach Anspruch 5, dadurch gekennzeichnet, dass als Anion $Z^{x-}$ ein Hexafluoroantimonat, Hexachloroantimonat, Hexafluoroarsenat, Pentachlorowismutat, Tetrachloroferrat, Hexachlorostannat, Tetrafluoroborat oder Hexafluorophosphat vorliegt.

7. Zusammensetzungen nach einem der Ansprüche 1 bis 6, dadurch gekennzeichnet, dass als kationisch polymerisierbares Material ein 1,2-Monoepoxid oder ein Epoxidharz vorliegt und das Diaryljodosylsalz ein Metallhalogenid- oder Metalloidhalogenidanion besitzt.

8. Zusammensetzungen nach einem der Ansprüche 1 bis 5, dadurch gekennzeichnet, dass als kationisch polymerisierbares Material ein Aminoplast oder Phenoplast und als Diaryljodosylsalz ein Acetat, Trifluoracetat, Methansulfonat, Benzolsulfonat, Toluol-p-sulfonat, Trifluormethansulfonat, Fluorid, Chlorid, Bromid, Jodat, Perchlorat, Nitrat, Sulfat, Hydrogensulfat, Phosphat oder Hydrogenphosphat vorliegt.

9. Zusammensetzungen nach einem der Ansprüche 1 bis 8, dadurch gekennzeichnet, dass sie 0,01% bis 10% des Diaryljodosylsalzes der Formel V, berechnet auf das Gewicht des kationisch polymerisierbaren Materials, enthalten.

10. Zusammensetzungen nach einem der Ansprüche 7 bis 9, dadurch gekennzeichnet, dass als kationisch polymerisierbares Material ein Epoxidharz oder Phenoplast vorliegt, wobei die Zusammensetzung ferner eine härtende Menge eines latenten Härters für das Epoxidharz oder Phenoplast enthält.

11. Verfahren zur Herstellung polymeren oder vernetzten Materials, dadurch gekennzeichnet, dass man eine Zusammensetzung nach einem der vorhergehenden Ansprüche Strahlung einer solchen Wellenlänge aussetzt, dass Polymerisation oder Vernetzung der Zusammensetzung eintritt.

12. Verfahren nach Anspruch 11, dadurch gekennzeichnet, dass die Zusammensetzung eine solche nach Anspruch 10 ist und das bestrahlte Produkt zur Vernetzung des Epoxidharzes oder Phenoplasts erhitzt wird.

## Claims

1. A photopolymerisable composition comprising at least one cationically polymerisable material and, as photoinitiator, at least one diaryliodosyl salt of formula

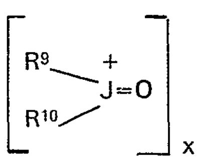 $Z^{x-}$ V

wherein $R^9$ and $R^{10}$ may be the same or different and each represent a monovalent aromatic radical which contains 4 to 25 carbon atoms and which is unsubstituted or contains substituents which do not interfere with the liberation of an acid compound when the diaryliodosyl salt is irradiated, x is 1, 2 or 3, and $Z^{x-}$ is an x-valent anion of a protic acid.

2. A composition according to claim 1, in which the groups $R^9$ and $R^{10}$ are unsubstituted or substituted thienyl, furyl, pyridyl, pyrazolyl, anthryl, phenanthryl, fluorenyl, phenyl or naphthyl groups, or groups of formula

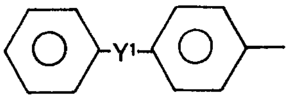

VI

wherein $Y^1$ is a carbon-carbon bond, an ether oxygen atom, or a group of formula $-CH_2-$ or $-C(CH_3)_2-$.

3. A composition according to either of claims 1 or 2, in which the groups $R^9$ and $R^{10}$ are substituted by alkyl or alkoxy groups of 1 to 4 carbon atoms, nitro groups or halogen atoms.

4. A composition according to any one of claims 1 to 3, in which the anion $Z^{x-}$ is derived from an organic carboxylic acid, an organic sulphonic acid $Y\text{-}SO_3H$, wherein $\gamma$ is an aliphatic, aromatic or aliphatic-substituted aromatic group which may be substituted by one or more halogen atoms, or from an inorganic acid.

5. A composition according to claim 4, in which the anion $Z^{x-}$ is an acetate, trifluoroacetate, methanesulphonate, benzenesulphonate, toluene-p-sulphonate, trifluoromethanesulphonate, fluoride, chloride, bromide, iodate, perchlorate, nitrate, sulphate, hydrogen sulphate, phosphate, hydrogen phosphate or pentafluorohydroxoantimonate, or is an anion of formula $MQ_w^-$, wherein M is an atom of a metal or metalloid, Q is a halogen atom, and w is an integer of from 4 to 6 and is one more than the valency of M.

6. A composition according to claim 5, in which the anion $Z^{x-}$ is a hexafluoroantimonate, hexachloroantimonate, hexafluoroarsenate, pentachlorobismuthate, tetrachloroferrate, hexachlorostannate, tetrafluoroborate or hexafluorophosphate.

7. A composition according to any one of claims 1 to 6, in which the cationically polymerisable material is a 1,2-monoepoxide or an epoxy resin and the diaryliodosyl salt has a metal halide or metalloid halide anion.

8. A composition according to any one of claims 1 to 5, in which the cationically polymerisable material is an aminoplast or a phenoplast and the diaryliodosyl salt is an acetate, trifluoroacetate, methanesulphonate, benzenesulphonate, toluene-p-sulphonate, trifluoromethanesulphonate, fluoride, chloride, bromide, iodate, perchlorate, nitrate, sulphate, hydrogen sulphate, phosphate or hydrogen phosphate.

9. A composition according to any one of claims 1 to 8, containing 0.01% to 10% of the diaryliodosyl salt of formula V, on the weight of the cationically polymerisable material.

10. A composition according to any one of claims 7 to 9, in which the cationically polymerisable material is an epoxy resin or a phenoplast, the composition also containing a curing amount of a latent hardener for the epoxy resin or phenoplast.

11. A process for the preparation of polymeric or crosslinked material, which comprises subjecting a composition as claimed in any one of the preceding claims to radiation of wavelength such as to effect polymerisation or crosslinking of the composition.

12. A process as claimed in claim 11, in which the composition is as claimed in claim 10 and the irradiated product is heated to crosslink the epoxy resin or the phenoplast.

## Revendications

1. Compositions photopolymérisables, caractérisées en ce qu'elles contiennent au moins une matière polymerisable par voie cationique et, à titre de photo-amorceur(s), au moins un sel de diaryliodosyle de formule:

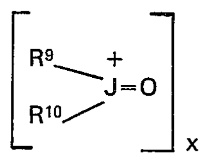

$Z^{x-}$

V

dans laquelle $R^9$ et $R^{10}$ peuvent être identiques ou différents et représentent chacun un reste aromatique monovalent, comportant 4 à 25 atomes de carbone, non substitué ou comportant des substituants qui ne gènent pas la mise en liberté d'un composé acide lors d'une exposition du sel de diaryliodosyle, x vaut 1, 2 ou 3 et $Z^{x-}$ représente un anion de valence x d'un acide protonique.

2. Compositions selon la revendication 1, caractérisées en ce qu'elles comportent, comme groupes $R^9$ et $R^{10}$, des groupes thiényle, furyle, pyridyle, pyrazolyle, anthryle, phénanthryle, fluorényle, phényle ou naphtyle éventuellement substitués, ou des groupes de formule:

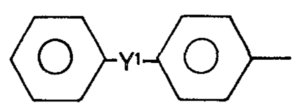

VI

dans laqquelle $Y^1$ représente une liaison carbone-carbone, un atome d'oxygène de fonction éther ou un groupe de formule: $-CH_2-$ ou $-C(CH_3)_2-$.

3. Compositions selon la revendication 1 ou 2, caractérisées en ce que les groupes $R^9$ et $R^{10}$ sont substitués par des groupes alkyles ou alcoxy comportant 1 à 4 atomes de carbone, par des groupes nitro ou par des atomes d'halogène.

4. Compositions selon l'une des revendications 1 à 3, caractérisées en ce que l'anion $Z^{x-}$ dérive d'un acide carboxylique organique, d'un acide sulfonique organique Y-$SO_3H$, dans lequel Y représente un groupe aliphatique, aromatique ou aromatique substitué par un groupe aliphatique, et éventuellement substitué par un ou plusieurs atomes d'halogène, ou il dérive d'un acide minéral.

5. Compositions selon la revendication 4, caractérisées en ce qu'il y a comme anion $Z^{x-}$ un anion acétate, trifluoracétate, méthanesulfonate, benzènesulfonate, toluène-p-sulfonate, trifluorométhane sulfonate, fluorure, chlorure, bromure, iodate, perchlorate, nitrate, sulfate, hydrogénosulfate, phosphate, hydrogénophosphate ou pentafluorohydroxoantimoniate ou un anion de formule $MQ_w^-$, dans laquelle M représente un atome de métal ou de métalloïde et Q représente un atome d'halogène, et w est un nombre entier valant 4 à 6 et qui est supérieur de 1 à la valence de M.

6. Compositions selon la revendication 5, caractérisées en ce qu'elles comportent comme anion $Z^{x-}$ un anion hexafluoroantimoniate, hexachloroantimoniate, hexafluoroarséniate, pentachlorobismutate, tétrachloroferrate, hexachlorostannate, tétrafluoroborate ou hexafluorophosphate.

7. Compositions selon l'une des revendications 1 à 6, caractérisées en ce qu'elles comportent comme matières polymérisables par voie cationique un monoépoxyde-1,2 ou une résine époxyde et en ce que le sel de diaryliodosyle comporte un anion halogénure de métal ou un anion halogénure de métalloïde.

8. Compositions selon l'une des revendications 1 à 5, caractérisées en ce qu'elles comportent, comme matières polymérisables par voie cationique, un aminoplaste ou un phénoplaste et, comme sels de diaryliodosyle, un acétate, trifluoracétate, méthanesulfonate, benzènesulfonate, toluène-p-sulfonate, trifluorométhanesulfonate, fluorure, chlorure, bromure, iodate, perchlorate, nitrate, sulfate, hydrogénosulfate, phosphate ou hydrogénophosphate.

9. Compositions selon l'une des revendications 1 à 8, caractérisées en ce qu'elles contiennent 0,01% à 10% du sel de diaryliodosyle de formule V, pourcentages calculés par rapport au poids de la matière polymérisable par voie cationique.

10. Compositions selon l'une des revendications 7 à 9, caractérisées en ce qu'elles contiennent comme matières polymérisables par voie cationique une résine époxyde ou un phénoplaste, la composition contenant en outre une quantité, capable d'effectuer un durcissement, d'un durcisseur latent de la résine époxyde ou du phénoplaste.

11. Procédé pour produire une matière polymère ou réticulée, caractérisé en ce qu'on expose une composition selon l'une des revendications précédentes à un rayonnement de longueurs d'ondes telles qu'il se produit une polymérisation ou une réticulation de la composition.

12. Procédé selon la revendication 11, caractérisé en ce que la composition est une composition selon la revendication 10 et en ce que l'on chauffe le produit, après son exposition, pour réticuler la résine époxyde ou le phénoplaste.